# EUROPÄISCHE PATENTSCHRIFT

(11) **EP 1 932 404 B1**
(45) Veröffentlichungstag und Bekanntmachung des Hinweises auf die Patenterteilung: **29.07.2009**
(21) Anmeldenummer: 06792749.1
(22) Anmeldetag: 09.08.2006
(51) Int. Cl.: H05K 5/00

(54) **STEUERGERÄT, INSBESONDERE FÜR EIN KRAFTFAHRZEUGGETRIEBE**
CONTROLLER, IN PARTICULAR FOR MOTOR VEHICLE TRANSMISSIONS
APPAREIL DE COMMANDE CONÇU EN PARTICULIER POUR UNE BOITE DE VITESSES DE VEHICULE AUTOMOBILE

(30) Priorität: 29.09.2005 DE 102005046826
(43) Veröffentlichungstag der Anmeldung: 18.06.2008
(73) Patentinhaber: ROBERT BOSCH GMBH, 70442 Stuttgart (DE)
(72) Erfinder: WETZEL, Gerhard, 70825 Korntal-Muenchingen (DE); SPRAFKE, Peter, 70469 Stuttgart (DE); TRESCHER, Ulrich, 72072 Tuebingen (DE)
(86) Internationale Anmeldenummer: PCT/EP2006/065172
(87) Internationale Veröffentlichungsnummer: WO 2007/036384

(56) Entgegenhaltungen:
- EP-A- 0 973 366
- EP-A- 1 239 710
- DE-A1- 10 315 432
- DE-A1- 19 856 839
- DE-C1- 10 051 945
- DE-U1- 8 309 870
- DE-U1- 20 120 373
- JP-A- 4 056 173
- US-A1- 4 443 145

## Beschreibung

### Stand der Technik

In der Kraftfahrzeugtechnik sind Steuergeräte bekannt, die zur Getriebesteuerung eingesetzt und werden und in ein Steuermodul eingebaut werden, das mit Sensoren, Steckverbindungen und gegebenenfalls Hydraulikventilen versehen ist und am Getriebe festgelegte wird. Das Steuergerät wird dabei dem aggressiven Getriebeöl ATF (Automatic Transmission Fluid) und hohen Temperaturen ausgesetzt. Ein für die Steuerfunktionen zuständiges elektronisches Schaltungsteil muss daher in einem öldichten Gehäuseinnenraum des Steuergerätes angeordnet werden. Ein Steuergerät mit den Merkmalen des Oberbegriffs des Anspruchs 1 ist beispielsweise aus der EP 1 239 710 A2 bekannt. Bei dem bekannten Steuergerät ist das elektronische Schaltungsteil auf ein metallisches Trägerteil aufgebracht, das wiederum auf einem Kühlkörper angeordnet ist. Auf dem Trägerteil ist weiterhin eine das Schaltungsteil umgebende großflächige flexible Leiterfolie auflaminiert. Hierzu weist die Leiterfolie eine Innenausnehmung aug in der das Schaltungsteil auf dem Trägerteil angeordnet ist. Ein mit einem Dichtungsmittel versehener Gehäusedeckel wird zur Abdichtung über dem Schaltungsteil auf die großflächige Leiterfolie aufgesetzt. Nachteilig an dem bekannten Steuergerät ist die Verwendung einer großflächigen und daher teuren Leiterfolie sowie die spezielle Weise der Abdichtung des Gehäuseinnerraumes, welche teilweise mittels der in den Gehäuseinnenraum hineinragenden Leiterfolie erfolgt. Es ist relativ aufwendig, Undichtigkeiten zwischen der Leiterfolie und dem Trägerteil einerseits und zwischen der Leiterfolie und dem Gehäusedeckel andererseits zu vermeiden.
DE-A-10315432 zeigt ein Steuergerät, bei dem das elektrische Schaltungsteil innerhalb eines Rahmenteils angeordnet ist und mittels Bonddrähten durch Aussparungen im Rahmenteil mit einem flexiblen Folienleiter auf einer Grundplatte verbunden ist.

### Vorteile der Erfindung

Das erfindungsgemäße Steuergerät gemäß Anspruch 1 und das erfindungsgemäße Verfahren zur Herstellung eines Steuergeräts, das in Anspruch 12 definiert ist, ermöglicht einen kostengünstigen Aufbau bei gleichzeitig großer Dichtheit gegenüber aggressiven Getriebesubstanzen und großer Beständigkeit gegenüber hohen Temperaturen. Auf eine großflächige und teure Leiterfolie kann vorteilhaft verzichtet werden. Stattdessen können mehrere flexible Leiberfolienstreifen verwandt werden, die im Nutzen kostengünstiger hergestellt werden können, da weniger Verschnitt vorliegt. Durch die Verwendung eines die elektronische Schaltung umgebenden Rahmenteils, welches mit dem Träger in einem umlaufenden Dichtbereich verbindbar ist, wird eine besonders zuverlässige Abdichtung des Gehäuseinnenraums erreicht. Die mit dem elektronischen Schaltungsteil versehenen elektrischen Verbindungsmittel werden erfindungsgemäß durch wenigstens eine Aussparung des Rahmenteils hindurch mit der wenigstens einen außerhalb des Gehäuseinnenraumes angeordneten Leiterfolie kontaktiert. Die Abdichtung des Gehäuseinnenraumes erfolgt daher nicht über die Leiterfolie und kann daher vorteilhaft beispielsweise auch mittels einer Schweißverbindungen zwischen Rahmenteil und Träger realisiert werden.

Vorteilhafte Ausführungsbeispiele und Weiterbildungen der Erfindung werden durch die in den abhängigen Ansprüchen beschriebenen Merkmale ermöglicht

Die von dem Träger abgewandte Seite des Rahmenteils kann mit einem Gehäusedeckel verschlossen werden, so dass ein dichter Gehäuseinnenraum entsteht. Die Abdichtung des Gehäuseinnenraumes kann vorteilhaft mittels einer Schweißverbindungen zwischen Rahmenteil und Gehäusedeckel erfolgen.

In einem vorteilhaften Ausführungsbeispiels liegt das Rahmenteil mit einem umlaufenden Anlagebereich auf der mit dem elektronischen Schaltungsteil versehenen Seite des Trägers außerhalb des elektronischen Schaltungsteils an. In diesem umlaufenden Bereich kann das Rahmenteil in einfacher Weise mit dem Träger beispielsweise durch Schweißen verbunden werden.

Besonders vorteilhaft ist ein Ausführungsbeispiel, bei dem das Rahmenteil einen ersten Wandabschnitt mit einer dem Träger zugewandten ersten Seite und einer dem Gehäuseinnenraum zugewandten zweiten Seite sowie einen vom dem ersten Wandabschnitt zu dem Gehäusedeckel hin abstehenden zweiten Wandabschnitt aufweist. Das Rahmenteil weist eine wannenartige Form auf Diese Form ist sehr hilfreich für die Auftragung eines Abdeckmaterials, beispielsweise eines Gels auf der elektronischen Schaltung.

Die wenigstens eine Aussparung kann insbesondere in dem ersten Wandabschnitt des Rahmenteils ausgebildet sein, wobei dieser erste Wandabschnitts mittelbar oder unmittelbar auf der flexiblen Leiterfolie aufliegt. In diesem Fall sind das Schaltungsteil und die Leiterfolie auf dem Träger parallel ausgerichtet und die Verbindungsmittel können in Form von Bonddrähten durch die Aussparung hindurch in einfacher Weise auf die außerhalb des Gehäuseinnenraums angeordnete Leiterfolie aufgebracht werden.

Zur Abdichtung der Aussparung ist vorgehen, dass der erste Wandabschnitt des Rahmenteils unter Zwischenlage eines die wenigstens eine Aussparung und eine Kontaktfläche der flexiblen Leiterfolie umgebenden Dichtungsmittels auf der flexiblen Leiterfolie aufliegt. Verschiedene Dichtungsmittel insbesondere Adhäsionsdichtungen oder Kompressionsdichtungen kommen hierfür in Frage.

In einem anderen Ausführungsbeispiel ist vorgesehen, dass der erste Wandabschnitt unter Zwischenlage eines mit einer Innenausnehmung zur Durchführung der elektrischen Verbindungsmittel versehenen Abstandshalters auf der flexiblen Leiterfolie aufliegt, wobei das Dichtungsmittel um den Abstandshalter herum zwischen dem ersten Wandabschnitt und der Leiterfolie angeordnet ist. Der beispielsweise aus Kunststoff gefertigte Abstandshalter kann in die Aussparung eingepresst werden und dient als Montagehilfe für das Dichtungsmittel und zur Einstellung des Abstandes zwischen dem ersten Wandabschnitt und der Leiterfolie. Wird als Dichtungsmittel ein elastischer Dichtungsring verwandt, so wird dieser um einen durch die Höhe des Abstandshalters definierten Betrag komprimiert.

Das erfindungsgemäße Steuergerät kann in sehr einfacher Weise hergestellt werden, indem in einem ersten Schritt zunächst die wenigstens eine leiterfolie auf den Träger aufgebracht werden. Werden mehrere flexible Leiterfolienstreifen verwandt, so können diese auf dem gemeinsamen Träger mit geringen Toleranzen angeordnet werden. Anschließend wird das Rahmenteil auf den Träger aufgesetzt, wobei die Aussparung des Rahmenteils durch Zwischenlage eines Dichtungsmittels abgedichtet werden kann. Das Rahmenteil kann an dem Träger mittels einer Schweißverbindung festgelegt werden. Anschleißend kann das elektronische Schaltungsteil innerhalb des Rahmenteils auf den Träger ausgesetzt und daran befestigt werden. Das Schaltungsteil kann aber auch vor der Aufbringung des Rahmenteils oder der Leiterfolie auf dem Träger angeordnet werden. Schließlich können die elektrischen Verbindungsmittel mit dem elektronischen Schaltungsteil und der flexiblen leiterfolie kontaktiert werden. Dies kann vorteilhaft in Form von Bonddrahtverbindungen zwischen den Kontaktflächen des Schaltungsteils und der Leiterfolie geschehen. Anschließend kann auf das Schaltungsteil und/oder die Aussparung ein Gel aufgetragen werden und zuletzt der Gehäusedeckel auf das Rahmenteil ausgesetzt werden.

### Zeichnungen

Ausführungsbeispiele der Erfindung sind in den Zeichnungen dargestellt und werden in der nachfolgenden Beschreibung erläutert. Es zeigt
- Fig. 1: einen Teilquerschnitt durch ein erstes Ausführungsbeispiel der Erfindung
- Fig. 2: eine Draufsicht auf das erste Ausführungsbeispiel bei abgenommenem Gehäusedeckel,
- Fig. 3a: eine perspektivische Ansicht eines zweiten Ausführungsbeispiels,
- Fig. 3b: einen Teilschnitt durch Fig. 3a,
- Fig. 4: einen Teilquerschnitt durch ein drittes Ausführungsbeispiels der Erfindung.

### Beschreibung der Ausführungsbeispiele

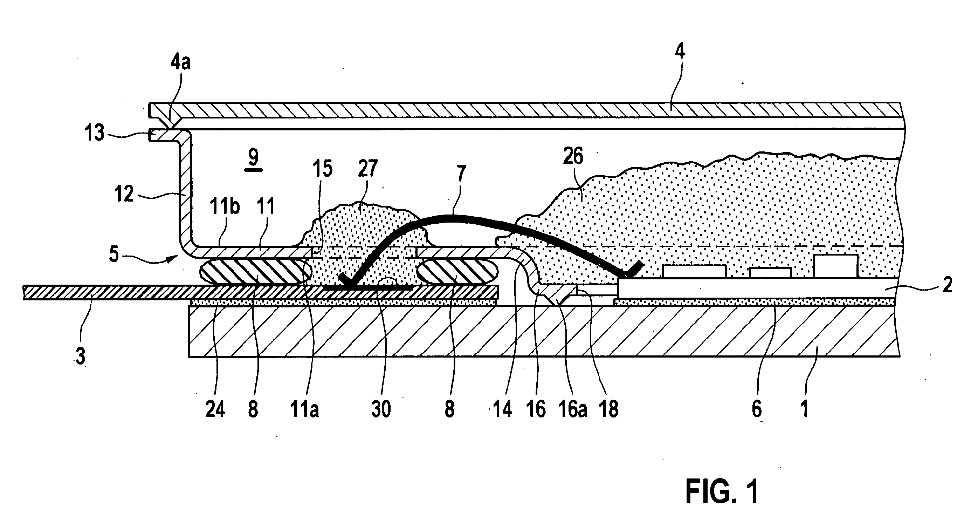

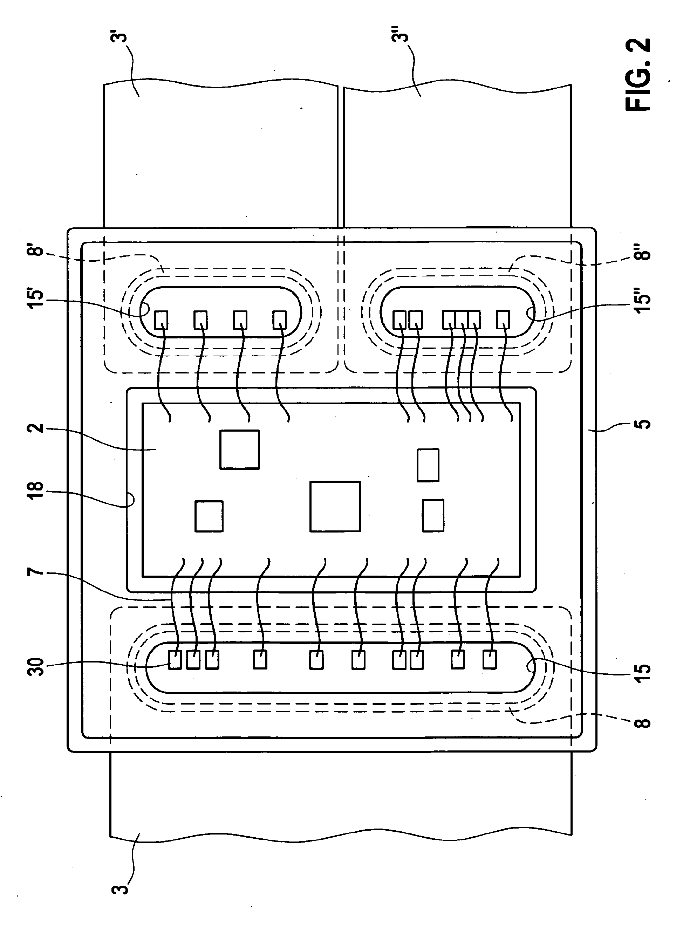

Fig. 1 zeigt ein erstes Ausführungsbeispiel des erfindungsgemäßen Steuergerätes. Bei dem Steuergerät handelt es sich beispielsweise um ein Getriebesteuergerät, wekhes in ein auf das Getriebe aufgesetztes Steuermodul eingebaut werden kann. Das Steuergerät weist einen Träger 1 auf, der beispielsweise als ebene metallische Trägerplatte aus Stahl oder Aluminium mit guter Wärmeableitung ausgebildet ist. Der Träger 1 kann an dem nicht dargestellten Steuermodul festgelegt werden und ist dort insbesondere mit einem Kühlkörper des Moduls wärmeleitend verbunden. Wie in Fig. 1 weiterhin zu erkennen ist, ist auf den Träger 1 ein elektronisches Schaltungsteil 2 aufgebracht Das elektronische Schaltungsteil 2 umfasst eine auf einem Trägersubstrat angeordnete elektronische Schaltung mit elektrischen und/oder elektronischen Bauelementen, wekhe zur Ansteuerung des Getriebes benötigt werden. Das Schaltungsteils ist vorzugsweise als LTCC (Low Temperature Cofired Ceramic) mit einem keramischen Trägersubstrat ausgebildet und wird beispielsweise über eine Kleberschicht 6 oder in anderer Weise auf den Träger 1 aufgebracht Wie in Fig. 1 und Fig. 2 zu erkennen ist, ist außerdem wenigstens eine flexible Leiterfolie 3 auf den Träger 1 auflaminiert, wobei ein Kleber 24 verwandt wird. Vorteilhaft können mehrere flexible Leiterfolien 3, 3', 3" in Streifenform auf den gemeinsamen Träger auflaminiert werden. Durch das Aufkleben der Leiterfolie 3, 3', 3"aufdie ebene Montageseite eines gemeinsamen Trägers 1 kann eine geringe Lagetoleranz der Leiterfolien zueinander eingehalten werden. Die flexiblen Leiterfolie 3, 3', 3" sind an ihren von dem Träger entfernten und in Fig. 1 und Fig. 2 nicht gezeigten Enden mit elektrischen oder elektronischen Bauelementen des Steuermoduls kontaktiert. Hierzu zählen beispielsweise Sensoren, Steckerteile oder Hydraulikventile. Das Aufkleben der Leiterfolien 3, 3', 3" dient der mechanischen Befestigung auf dem Träger und der Zugentlastung der elektrischen Verbindungsstellen zum Schaltungsteil 2. Durch den Kleber 24 wird auch vorteilhaft erreicht, dass sich Zugkräfte nicht nur auf die Dichtungsmittel am Steuergerätegehäuse einwirken. Die Leiterfolien können auch vor der Aufbringung des Schaltungsteils 2 auf den Träger 1 auflaminiert werden.

Wie in Fig. 1 und Fig. 2 weiterhin dargestellt ist, wird nach Montage der Leiterfolien ein vorzugsweise metallisches Rahmenteil 5 auf den Träger aufgesetzt. Das Rahmenteil kann aber auch aus Kunststoffhergestellt werden. Das Rahmenteil 5 hat eine wannenartige Form mit einer Innenausnehmung 18 und wird so auf den Träger 1 aufgesetzt, dass das elektronische Schaltungsteil in der Innenausnehmung 18 angeordnet ist und das Schaltungsteil 2 an vier Seiten von dem Rahmenteil 5 umgeben wird. Das Rahmenteil 5 weist einen ersten im wesentlichen ebenen Wandabschnitt 11 auf, der in etwa parallel zu der mit dem Schaltungsteil 2 versehenen Seite des Trägers 1 angeordnet ist. Der erste Wandabschnitt 11 weist eine dem Träger 1 zugewandte erste Seite 11a und eine davon abgewandte zweite Seite 11b auf Das Rahmenteil weist weiterhin einen von dem ersten Wandabschnitt 11 abgebogenen zweiten Wandabschnitt 12 auf, der eine seitlich umlaufende Begrenzungswand des Steuergerätegehäuses bildet und mit einem Kragen 13 versehen ist. Der erste Wandabschnitt 11 ist mit Aussparungen 15, 15' und 15" zur Durchführung von elektrischen Verbindungsmitteln 7 versehen. Zwischen dem ersten Wandabschnitt 11 und den Leiterfolien 3, 3', 3" ist ein die jeweilige Aussparung umgebendes Dichtungsmittel 8, 8', 8" vorgesehen. Als Dichtungsmittel kommt beispielsweise eine Adhäsionsdichtung in Form eines umlaufenden Dichtkleberwulstes in Frage, der einerseits nach der Auftragung auf der jeweiligen Leiberfolie 3, 3', 3" formstabil bleibt und nicht verläuft und andererseits eine ausreichend kleine Viskosität aufweist, um nach dem Aufsetzen des Rahmenteils 5 die jeweilige Leiterfolie und das Rahmenteil im Dichtbereich vollständig zu benetzen. Die Menge des aufgebrauchten Dichtklebers bemisst sich nach der Breite und Höhe des Spalts zwischen Leiterfolie und Rahmenteil 5. Jeder Dichtkleberwulst 8, 8', 8" wird jeweils auf der zugeordneten Leiterfolie 3, 3', 3 "um den mit den Kontaktflächen 30 versehenen Bereich der Leiterfolie herum umlaufend aufgetragen, wie am besten in Fig. 2 zu erkennen ist Anschließend kann das Rahmenteil 5 ausgesetzt werden und der Dichtkleber ausgehärtet werden.

An der dem elektronischen Schaltungsteil 2 zugewandten und von dem zweiten Wandabschnitt 12 abgewandten Innenseite des ersten Wandabschnitts 11 ist ein zu dem Träger 1 hin abgebogener Abschnitt 14 angeordnet, an den sich ein in etwa parallel zu dem Träger verlaufender Anlagebereich 16 abschließt der beispielsweise mit einer Rippe 16a unmittelbar auf dem metallischen Träger anliegt und die Innenausnehmung 18 umrandet. Die Befestigung des Rahmenteils 5 an dem Träger kann über eine Verschweißung des Anlagebereichs 16 mit dem Träger 1 im Bereich der Rippe 16a erfolgen. Dies kann insbesondere als Widerstandsschweißung (Kondensatorentladungsschweißen) oder als Laserschweißung ausgeführt werden. Es ist vorteilhaft, das elektronische Schaltungsteil 2 erst nach dem Verscheißen des Rahmenteils 5 mit dem Träger 1 auf den Träger auszubringen, um eine mögliche Beschädigung des empfindlichen Schaltungsteils durch den Schweißvorgang zu vermeiden.

Nach dem Verschweißen des Rahmenteils 5 mit dem Träger 1 und der Aufbringung des Schaltungsteils 2 werden Bondlands des elektronischen Schaltungsteils 2 mit den Kontaktflächen 30 der Leiterfolien 3, 3', 3" über elektrische Verbindungsmittel 7 in Form von Bonddrähten kontaktiert. Hierzu können beispielsweise Aluminium-Bonds verwandt werden. Nach der Herstellung der Bonddrahtverbindung kann das Schaltungsteil mit einer Gelabdeckung versehen werden. Hierzu wird ein erstes Gel 26 (beispielsweise ein preisgünstiges Standard-Gel) auf das Schaltungsteil aufgetragen. Durch den zum Träger 1 hin abgebogenen Abschnitt 14 des Rahmenteils 5 wird eine Aufnahme für das Gel bei der Auftragung geschaffen, wodurch das Gel davon abgehalten wird, auf den ersten Wandabschnitt 11 zu gelangen. Im Bereich der Aussparungen 15, 15', 15" kann daher ein zweites Gel 27 mit einer anderen Konsistenz (beispielsweise ein hochbeständiges fluoriertes Gel) aufgetragen werden, das den von dem jeweiligen Dichtungsmittel 8, 8', 8" umschlossenen Raum über den Kontaktflächen 30 bis zur Höhe der jeweiligen Aussparung 15, 15', 15" auffüllt, wodurch die Kontaktflächen 30 geschützt werden. Der abgebogene Abschnitt 14 verhindert ein Ineinanderlaufen von erstem Gel und zweiten Gel. Das erste Gel 26 und das zweite Gel 27 können gemeinsam ausgehärtet werden, wobei über das noch nicht verschlossene Rahmenteil 5 vorteilhaft eine Entlüftung erfolgt.

Zuletzt wird ein Gehäusedeckel 4 auf das Rahmenteil 5 aufgesetzt. Der Gehäusedeckel weist eine umlaufende Rippe 4a auf, die auf dem Kragen 13 des Rahmenteils 5 zur Anlage gelangt. In diesem Bereich wird das Rahmenteil 5 mit dem Gehäusedeckel 4 verschweißt, wodurch ein geschlossener Gehäuseinnenraum 9 entsteht. Der Gehäusedeckel kann aber auch in anderer Form an dem Rahmenteil festgelegt werden. Beispielsweise durch Bördeln oder Dichtkleben. Träger 1, Rahmenteil 5 und Gehäusedeckel 4 können vorteilhaft aus dem gleichen metallischen Werkstoffhergestellt werden. Durch die gleichen Ausdehnungskoeffizienten werden die thermisch induzierten Spannungen auf die Polymere Dichtung zwischen Leiterfolie und Rahmenteil minimiert.

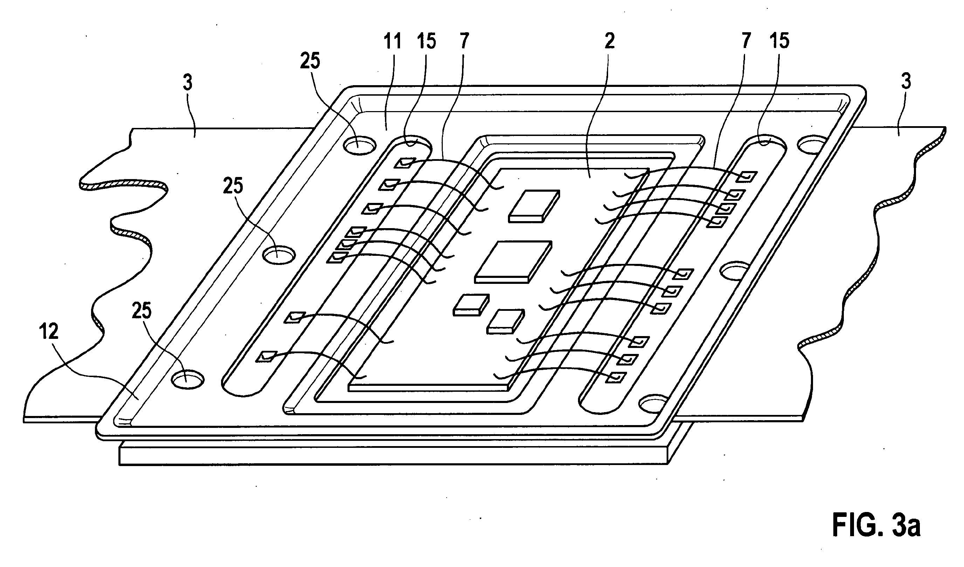

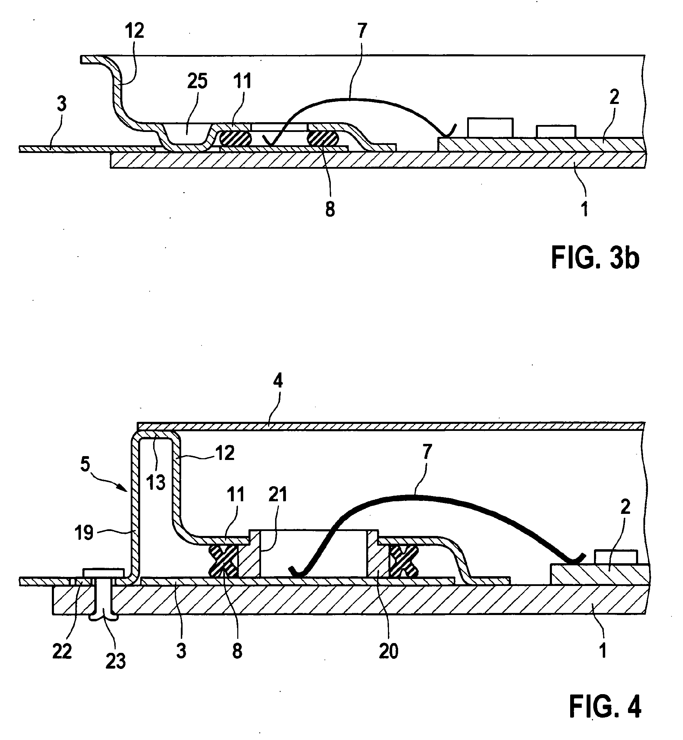

Ein zweites Ausführungsbeispiel ist in Fig. 3a und Fig. 3b dargestellt Bei diesem Ausführungsbeispiel ist der erste Wandabschnitt 11 des Rahmenteils 5 vom Gehäuseinnenraum aus gesehen mit Vertiefungen 25 versehen, die auf der dem Träger 1 zugewandten Seite 11a des ersten Wandabschnitts 11 zum Träger hin vorstehende Vorsprünge bilden, die durch Ausnehmungen der Leiterfolien hindurch unmittelbar auf dem Träger 1 aufliegen und mit diesem zur mechanischen Festlegung des Rahmenteils 5 an dem Träger 1 verschweißt werden.

Ein viertes Ausführungsbeispiel ist in Fig. 4 dargestellt Bei diesem Ausführungsbeispiel ist ein hülsenartiger Abstandshalter 20 aus Kunststoff in die Aussparung 15 des Rahmenteils 6 eingepresst Durch den Abstandshalter 20 wird der Abstand zwischen dem ersten Wandabschnitt 11 des Rahmenteils 5 und der flexiblen Leiterfolie 3 eingestellt Der Abstandshalter 20 weist eine Innenausnehmung 21 auf, durch die die elektrischen Verbindungsmittel 7 hindurch mit den Kontaktflächen 30 der Leiterfolie 3 kontaktiert sind. Das Dichtungsmittel 8 ist in diesem Ausführungsbeispiel als Kompressionsdichtung in Form eines fluorierten Elastomers ausgebildet, das unter radialer Vorspannung auf den Abstandshalter 20 aufgeschoben wird. Der Abstandshalter dient daher sowohl als Montagehilfe für das Dichtungsmittel 8 als auch zur Einstellung einer definierten Kompression des Dichtungsmittels 8.

Weiterhin ist in diesem Ausführungsbeispiel ein weiterer Wandschnitt 19 des Rahmenteils 5 vorgesehen, der sich an den Kragen 13 anschließt, zum Träger 1 hin abgewinkelt ist und der mit einem parallel zum Träger 1 verlaufenden abgebogenen Abschnitt 22 versehen ist. Der Abschnitt 22 ist mit Befestigungsmitteln 23, beispielsweise in Form von Schrauben oder Nieten an dem Träger festgelegt. Natürlich kann der Abschnitt 22 auch mit dem Träger 1 verschweißt werden, wobei die Schweißstelle auch wie in Fig. 3b dargestellt ausgeführt werden kann.

Bei der Ausgestaltung der Dichtungsmittel 8, 8', 8" in Form von Kompressionsdichtungen gibt es die weitere Möglichkeit, die Dichtungsmittel an das Rahmenteil 5 anzuspritzen bzw. durch Vulkanisierung an dem Rahmenteil auszubilden. Dabei stellt sich ein weiterer Vorteil ein. Außer den Dichtungsmitteln 8 können auch zusätzlich die Dichtungen zwischen dem Rahmenteil und dem Gehäusedeckel oder zwischen dem Rahmenteil und dem Träger als Kompressionsdichtungen ausgeführt werden. Vorteilhaft kann hierbei das Vulkanisieren der Dichtungen getrennt von der Leiterfolie durchgeführt werden, wodurch entstehende Reaktionsprodukte die Sauberkeit der Kontaktflächen der Leiterfolie nicht beeinträchtigen.

## Patentansprüche

1. Steuergerät, insbesondere für Kraftfahrzeuggetriebe, mit einem Träger (1), auf den ein elektronisches Schaltungsteil (2) aufgebraucht ist und an dem wenigstens eine über elektrische Verbindungsmittel (7) mit dem elektronischen Schaltungsteil (2) verbundene flexible Leiterfolie (3) angeordnet ist, wobei ein mit einer Innenausnehmung (18) versehenes und das elektronische Schaltungsteil (2) umgebendes Rahmenteil (5) auf dem Träger (1) derart angeordnet ist, dass das elektronische Schaltungsteil (2) in der Innenausnehmung (18) des Rahmenteils angeordnet ist, und dass die mit dem elektronischen Schaltungsteil verbundenen elektrischen Verbindungsmittel (7) durch wenigstens eine Aussparung (15) des Rahmenteils (5) hindurch mit der wenigstens einen flexiblen Leiterfolie (3) elektrisch verbunden sind.

2. Steuergerät nach Anspruch 1, **dadurch gekennzeichnet, dass** das Rahmenteil (5) auf der von dem Träger (1) abgewandten Seite mit einem Gehäusedeckel (4) abgedeckt ist, wobei das Rahmenteils, der Gehäusedeckel und der Träger einen das elektronische Schalungsteil (2) bergenden Gehäuseinnenraum (9) bilden.

3. Steuergerät nach Anspruch 2, **dadurch gekennzeichnet, dass** die flexible Leiterfolie (3) außerhalb des durch das Rahmenteil (5), den Gehäusedeckel (4) und den Träger (1) gebildeten Gehäuseinnenraumes (9) angeordnet ist.

4. Steuergerät nach Anspruch 1, **dadurch gekennzeichnet, dass** das Rahmenteil (5) mit einem umlaufenden Anlagebereich (16) auf der mit dem elektronischen Schaltungsteil (2) versehenen Seite des Trägers (1) außerhalb des elektronischen Schaltungsteils anliegt und dort insbesondere mit dem Träger (1) umlaufend verschweißt ist.

5. Steuergerät nach Anspruch 1, **dadurch gekennzeichnet, dass** das Rahmenteil (5) einen ersten Wandabschnitt (11) mit einer dem Träger zugewandten ersten Seite (11a) und einer dem Gehäuseinnenraum (9) zugewandten zweiten Seite (11b) sowie einen vom dem ersten Wandabschnitt (11) zu dem Gehäusedeckel (4) hin abstehenden zweiten Wandabschnitt (12) aufweist.

6. Steuergerät nach Anspruch 5, **dadurch gekennzeichnet, dass** die wenigstens eine Aussparung (15) in dem ersten Wandabschnitt (11) des Rahmenteils (5) vorgesehen ist und dass der erste Wandabschnitts (11) wenigstens mittelbar auf der flexiblen Leiterfolie (3) aufliegt.

7. Steuergerät nach Anspruch 6, **dadurch gekennzeichnet, dass** der erste Wandabschnitt (11) des Rahmenteils (5) unter Zwischenlage eines die wenigstens eine Aussparung (15) des Rahmenteils und eine Kontakfläche (30) der flexiblen Leiterfolie (3) umgebenden Dichtungsmittels (8) auf der flexiblen Leiterfolie aufliegt.

8. Steuergerät nach Anspruch 7, **dadurch gekennzeichnet, dass** der erste Wandabschnitt (11) unter Zwischenlage eines mit einer Innenausnehmung (21) zur Durchführung der elektrischen Verbindungsmittel (7) versehenen Abstandhalters (20) auf der flexiblen Leiterfolie (3) auflegt, wobei das Dichtungsmittel (8) um den Abstandshalter (20) herum zwischen dem ersten Wandabschnitt (11) und der Leiterfolie angeordnet ist.

9. Steuergerät nach Anspruch 1, **dadurch gekennzeichnet, dass** das Rahmenteil (5) wenigstens einen Abschnitt (16, 25) aufweist, der mit dem Träger (1) verschweißt ist

10. Steuergerät nach einem der vorstehenden Ansprüche, **dadurch gekennzeichnet, dass** mehrere flexible Leiterfolie (3, 3', 3") auf dem Träger (1) angeordnet sind, denen jeweils eine Aussparung (15, 15', 15") in dem Rahmenteil zugeordnet ist, wobei die mit einer Leiterfolie verbundenen Verbindungsmittel (7) durch die der jeweiligen Leiterfolie zugeordnete Aussparung (15, 15', 15") hindurch mit dem Schaltungsteil (2) elektrisch verbunden sind.

11. Steuergerät nach einem der vorstehenden Ansprüche, **dadurch gekennzeichnet, dass** die elektrischen Verbindungsmittel (7) in Form von Bonddrähten ausgebildet sind.

12. Verfahren zur Herstellung eines Steuergerätes nach einem der vorstehenden Ansprüche, **dadurch gekennzeichnet, dass** in einem ersten Schritt die wenigstens eine Leiterfolie (3) an dem Träger (1) festgelegt wird, dass danach das Rahmenteil (5) auf den Träger aufgesetzt und mittels einer Schweißverbindung an dem Träger festgelegt wird und anschließend die elektrischen Verbindungsmittel (7) mit der flexiblen Leiterfolie (3) und einem vor oder nach der Aufbringung des Rahmenteils an dem Träger (1) festgelegten elektronischen Schaltungsteil (2) kontaktiert werden und dass schließlich der Gehäusedeckel (4) auf das Rahmenteil (5) ausgesetzt wird.

## Claims

1. Control unit, in particular for motor vehicle transmissions, comprising a carrier (1), to which an electronic circuit part (2) is applied and on which is arranged at least one flexible conductor film (3) connected to the electronic circuit part (2) via electrical connecting means (7), wherein a frame part (5), which is provided with an internal cutout (18) and surrounds the electronic circuit part (2), is arranged on the carrier (1) in such a way that the electronic circuit part (2) is arranged in the internal cutout (18) of the frame part, and that the electrical connecting means (7) connected to the electronic circuit part are electrically connected to the at least one flexible conductor film (3) through at least one cutout (15) in the frame part (5).

2. Control unit according to Claim 1, **characterized in that** the frame part (5) is covered with a housing cover (4) on the side remote from the carrier (1), wherein the frame part, the housing cover and the carrier form a housing interior (9) accommodating the electronic circuit part (2).

3. Control unit according to Claim 2, **characterized in that** the flexible conductor film (3) is arranged outside the housing interior (9) formed by the frame part (5), the housing cover (4) and the carrier (1).

4. Control unit according to Claim 1, **characterized in that** the frame part (5) bears with a circumferential bearing region (16) on that side of the carrier (1) which is provided with the electronic circuit part (2), outside the electronic circuit part, and is circumferentially welded there in particular to the carrier (1).

5. Control unit according to Claim 1, **characterized in that** the frame part (5) has a first wall section (11) having a first side (11a), which faces the carrier, and a second side (11b), which faces the housing interior (9), and also a second wall section (12), which projects from the first wall section (11) towards the housing cover (4).

6. Control unit according to Claim 5, **characterized in that** the at least one cutout (15) is provided in the first wall section (11) of the frame part (5), and **in that** the first wall section (11) lies at least indirectly on the flexible conductor film (3).

7. Control unit according to Claim 6, **characterized in that** the first wall section (11) of the frame part (5) lies on the flexible conductor film with interposition of a sealant (8) surrounding the at least one cutout (15) in the frame part and a contact area (30) of the flexible conductor film (3).

8. Control unit according to Claim 7, **characterized in that** the first wall section (11) lies on the flexible conductor film (3) with interposition of a spacer (20) provided with an internal cutout (21) for leading through the electrical connecting means (7), wherein the sealant (8) is arranged around the spacer (20) between the first wall section (11) and the conductor film.

9. Control unit according to Claim 1, **characterized in that** the frame part (5) has at least one section (16, 25) which is welded to the carrier (1).

10. Control unit according to any of the preceding claims, **characterized in that** a plurality of flexible conductor films (3, 3', 3") are arranged on the carrier (1), which are respectively assigned a cutout (15, 15', 15") in the frame part, wherein the connecting means (7) connected to a conductor film are electrically connected to the circuit part (2) through the cutout (15, 15', 15") assigned to the respective conductor film.

11. Control unit according to any of the preceding claims, **characterized in that** the electrical connecting means (7) are embodied in the form of bonding wires.

12. Method for producing a control unit according to any of the preceding claims, **characterized in that**, in a first step, the at least one conductor film (3) is fixed to the carrier (1), **in that** afterwards the frame part (5) is placed onto the carrier and fixed to the carrier by means of a welding connection and subsequently the electrical connecting means (7) are contact-connected to the flexible conductor film (3) and an electronic circuit part (2) fixed to the carrier (1) before or after the application of the frame part, and **in that** finally the housing cover (4) is placed onto the frame part (5).

## Revendications

1. Module de commande, notamment pour boîte de vitesses de véhicule automobile, comprenant un support (1) sur lequel est monté un élément de commutation électronique (2) et sur lequel se trouve au moins un film conducteur souple (3) relié avec l'élément de commutation électronique (2) par le biais de moyens de liaison électriques (7), un élément cadre (5) muni d'un creux intérieur (18) et qui entoure l'élément de commutation électronique (2) étant disposé sur le support (1) de telle sorte que l'élément de commutation électronique (2) est disposé dans le creux intérieur (18) de l'élément cadre et que les moyens de liaison électriques (7) reliés avec l'élément de commutation électronique sont reliés électriquement avec l'au moins un film conducteur souple (3) à travers au moins un creux (15) de l'élément cadre (5).

2. Module de commande selon la revendication 1, **caractérisé en ce que** l'élément cadre (5) est recouvert par un couvercle de boîtier (4) sur le côté opposé au support (1), l'élément cadre, le couvercle de boîtier et le support formant un espace intérieur de boîtier (9) accueillant l'élément de commutation électronique (2).

3. Module de commande selon la revendication 2, **caractérisé en ce que** le film conducteur souple (3) est disposé à l'extérieur de l'espace intérieur de boîtier (9) formé par l'élément cadre (5), le couvercle de boîtier (4) et le support (1).

4. Module de commande selon la revendication 1, **caractérisé en ce que** l'élément cadre (5) repose avec une zone d'appui périphérique (16) sur le côté du support (1) muni de l'élément de commutation électronique (2) à l'extérieur de l'élément de commutation électronique et y est soudé sur son pourtour, notamment avec le support (1).

5. Module de commande selon la revendication 1, **caractérisé en ce que** l'élément cadre (5) présente une première section de paroi (11) avec un premier côté (11a) qui fait face au support et un deuxième côté (llb) qui fait face à l'espace intérieur de boîtier (9) ainsi qu'une deuxième section de paroi (12) qui fait saillie de la première section de paroi (11) en direction du couvercle de boîtier (4).

6. Module de commande selon la revendication 5, **caractérisé en ce que** l'au moins un creux (15) est prévu dans la première section de paroi (11) de l'élément cadre (5) et que la première section de paroi (11) repose au moins indirectement sur le film conducteur souple (3).

7. Module de commande selon la revendication 6, **caractérisé en ce que** la première section de paroi (11) de l'élément cadre (5) repose sur le film conducteur souple en intercalant un moyen d'étanchéité (8) qui entoure l'au moins un creux (15) de l'élément cadre et une surface de contact (30) du film conducteur souple (3).

8. Module de commande selon la revendication 7, **caractérisé en ce que** la première section de paroi (11) repose sur le film conducteur souple (3) en intercalant une entretoise (20) munie d'un creux d'espace intérieur (21) destiné au passage du moyen de liaison électrique (7), le moyen d'étanchéité (8) étant disposé autour de l'entretoise (20) entre la première section de paroi (11) et le fil conducteur.

9. Module de commande selon la revendication 1, **caractérisé en ce que** l'élément cadre (5) présente au moins une section (16, 25) qui est soudée avec le support (1).

10. Module de commande selon l'une des revendications précédentes, **caractérisé en ce que** plusieurs films conducteurs souples (3, 3', 3") sont disposés sur le support (1), auxquels est respectivement associé un creux (15, 15', 15") dans l'élément cadre, les moyens de liaison (7) reliés avec un fil conducteur étant reliés électriquement avec l'élément de commutation (2) à travers le creux (15, 15', 15") associé au film conducteur correspondant.

11. Module de commande selon l'une des revendications précédentes, **caractérisé en ce que** les moyens de liaison électriques (7) sont réalisés sous la forme de fils de bonding.

12. Procédé de fabrication d'un module de commande selon l'une des revendications précédentes, **caractérisé en ce que** dans une première étape, l'au moins un film conducteur souple (3) est fixé sur le support (1), que l'élément cadre (5) est ensuite déposé sur le support et fixé au support au moyen d'une liaison soudée et qu'ensuite les moyens de liaison électriques (7) sont mis en contact avec le film conducteur souple (3) et un élément de commutation électronique (2) fixé sur le support (1) avant ou après la mise en place de l'élément cadre, et que finalement le couvercle de boîtier (4) est posé sur l'élément cadre (5).
